(19) Europäisches Patentamt
European Patent Office
Office européen des brevets

(11) Publication number : **0 453 317 A2**

# (12) EUROPEAN PATENT APPLICATION

(21) Application number : **91303554.9**

(51) Int. Cl.[5] : **G03F 7/028**

(22) Date of filing : **19.04.91**

(30) Priority : **20.04.90 JP 102982/90**

(43) Date of publication of application : **23.10.91 Bulletin 91/43**

(84) Designated Contracting States : **DE FR GB IT NL**

(71) Applicant : **CANON KABUSHIKI KAISHA**
**30-2, 3-chome, Shimomaruko, Ohta-ku**
**Tokyo (JP)**

(72) Inventor : **Kagami, Kenji, c/o Oriental Photo Industrial Co., Ltd., 24-40, Minamihara 1-chome, Hiratsuka-shi, Kanagawa-ken (JP)**
Inventor : **Fukui, Tetsuro c/o Canon K.K., 30-2, 3-chome Shimomaruko, Ohta-ku, Tokyo (JP)**
Inventor : **Katayama, Masato c/o Canon K.K., 30-2, 3-chome Shimomaruko, Ohta-ku, Tokyo (JP)**
Inventor : **Suzuki, Masao, c/o Oriental Photo Industrial Co., Ltd., 24-40, Minamihara 1-chome, Hiratsuka-shi, Kanagawa-ken (JP)**

(74) Representative : **Beresford, Keith Denis Lewis et al**
**BERESFORD & Co. 2-5 Warwick Court High Holborn**
**London WC1R 5DJ (GB)**

## (54) Image forming medium.

(57) An image forming medium has an image forming layer. This layer contains at least a polymerizable polymer precursor, a photopolymerization initiator represented by the following Formula (I), a photosensitive silver halide, an organic silver salt and a reducing agent represented by the following Formula (II) or (III).

EP 0 453 317 A2

## BACKGROUND OF THE INVENTION

### Field of the Invention

The present invention relates to an an image forming medium containing a silver halide and capable of forming a polymer image by the action of light.

### Related Background Art

Energies used to form or record an image include light, sound, electricity, magnetism, heat, radiations such as electron rays and X-rays, and chemical energy, among which, in particular, widely used are light, electricity, heat energy, or a combination of any of these.

For example, the image forming method that employs the combination of light energy with chemical energy includes a silver salt photographic process and a method in which a diazo copying paper is used. The method that employs the combination of light energy with electric energy includes an electrophotographic system. The method that utilizes heat energy also includes a method in which a thermal recording paper or transfer recording paper is used. On the other hand, known as the method that utilizes electric energy is a method in which an electrostatic recording paper, electrothermal recording paper, or electrosensitive recording paper is used.

Of the above image forming methods, the silver salt photographic process can obtain an image having a high resolution. The silver salt photographic process, however, requires the developing and fixing that uses complicated liquid compositions, or the drying of an image (or a print).

Now, development is energetically made on image forming methods that can form an image through a simple processing.

For example, U.S. Patent No. 4,629,676 teaches a method in which polymerization reaction under dry (thermal) conditions is caused by the photosensitive reaction of silver halide that acts as a trigger, to form an image comprising a polymer.

This method has the advantage that any complicated wet processing is not required, but has had the disadvantage that the polymer formation rate (i.e., polymerization rate of a polymeric compound) is so low that it takes a long time to form the polymer image. Incidentally, this disadvantage arises presumably because of a reaction intermediate (which functions as a polymerization initiator) formed in the course of heating, by the reaction between silver produced from silver halide by imagewise exposure and a reducing agent, which intermediate is so stable and has so low activity as the polymerization initiator that the polymerization reaction can not proceed so rapidly.

On the other hand, to cope with this problem to accelerate the polymerization, Japanese Patent Application Laid-open No. 52-70836 discloses a method in which a thermal polymerization initiator is used.

This method comprises forming a latent image comprising silver metal produced from silver halide by imagewise exposure, converting, under heating, a reducing agent into an oxidized product having a polymerization inhibitory powder different from that of said reducing agent by utilizing a catalytic action of the above silver metal, thereby producing a difference in the polymerization inhibitory power between the reducing agent and the resulting oxidized product and also causing a thermal polymerization reaction utilizing the thermal polymerization initiator, thus forming a polymer image corresponding with the difference in the polymerization inhibitory power.

This method, however, has been involved in the disadvantage that a good contrast can be made with difficulty in the polymer image.

This disadvantage arises presumably because the oxidation-reduction reaction taking place in a latent image portion to form the oxidized product and the polymerization reaction to form the polymer image are allowed to take place in the same heating step, so that these reactions may proceed in a competitive fashion and thus the respective reactions may not proceed in a good efficiency.

The image formation according to this method is very unstable in that, for example, the areas on which the polymer is formed may turn into exposed areas or unexposed areas only because of a slight change in the amount of the reducing agent.

In addition, U.S. Patent No. 4,649,098 discloses a method in which a reducing agent having a polymerization inhibitory power is brought into an oxidized product by imagewise consumption (at imagewise exposed areas) in the course of the developing of silver halide, and, after imagewise inhibition (at imagewise unexposed areas) of polymerization reaction by the action of the residual reducing agent, light energy is uniformly applied (whole areal exposure) from the outside to cause photopolymerization at the area at which the reducing agent has been consumed, thus forming a polymer image.

As a method of obtaining a polymer image with a good contrast, our research group has proposed a method

comprising subjecting an image forming medium containing at least a photosensitive silver halide, an organic silver salt, a reducing agent, a polymerizable polymer precursor and a photopolymerization initiator, to imagewise exposure followed by heating to produce a light-absorbing organic compound in said image forming medium, and subjecting said image forming medium in which said light-absorbing organic compound has been produced, to polymerization exposure to cause said polymerizable polymer precursor to polymerize; where the light-absorption characteristics of said light-absorbing organic compound are utilized to suppress the polymerization of said polymerizable polymer precursor at the area at which said light-absorbing organic compound has been produced.

## SUMMARY OF THE INVENTION

An object of the present invention is to provide an image forming medium from which a polymer image having a much better contrast can be taken out.

According to the present invention, there is provided an image forming medium comprising an image forming layer containing at least a polymerizable polymer precursor, a photopolymerization initiator represented by the following Formula (I), a photosensitive silver halide, an organic silver salt and a reducing agent represented by the following Formula (II) or (III).

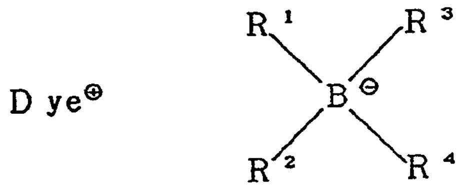

(I)

wherein $Dye^{\oplus}$ represents a cationic coloring matter moiety; $R^1$, $R^2$, $R^3$ and $R^4$ each independently represent a halogen atom, an alkyl group, an alkenyl group, an alkynyl group, an alicyclic group, an aryl group, an aryloxy group, an aralkyl group or a heterocyclic group, and may be the same with or different from each other; and $R^1$ and $R^2$, or $R^2$ and $R^3$ may combine to form a cyclic compound.

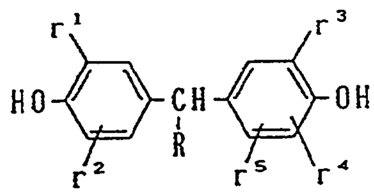

(II)

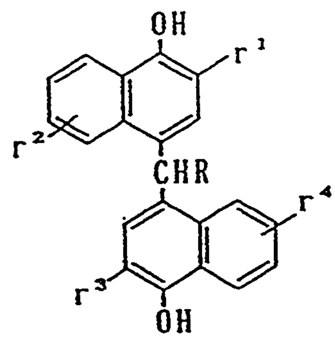

(III)

wherein $r^1$ and $r^3$ each independently represent a hydrogen atom, a substituted or unsubstituted alkyl group, a substituted or unsubstituted cycloalkyl group or a substituted or unsubstituted aralkyl group; $r^2$, $r^4$ and $r^5$ each independently represent a hydrogen atom, a halogen atom, a substituted or unsubstituted alkyl group, a substituted or unsubstituted cycloalkyl group, a substituted or unsubstituted aryl group, a substituted or unsubstituted aralkyl group or an alkoxyl group, where $r^4$ and $r^5$ may combine to form a ring; and R represents a hydrogen atom, a substituted or unsubstituted alkyl group, a substituted or unsubstituted aryl group or a substituted or unsubstituted aralkyl group.

## BRIEF DESCRIPTION OF THE DRAWINGS

Fig. 1 is a cross section to show an example of the image forming medium according to the present invention.

Fig. 2 is a cross section to show another example of the image forming medium according to the present invention.

## DESCRIPTION OF THE PREFERRED EMBODIMENTS

As shown in Fig. 1, the image forming medium of the present invention comprises at least an image forming layer 1 provided on a support 2. The image forming layer 1 contains a photosensitive silver halide, an organic silver salt, a reducing agent, a polymerizable polymer precursor, and a photopolymerization initiator. In the image forming medium of the present invention, the organic silver salt and reducing agent contained in the image forming layer 1 undergo oxidation-reduction reaction as a result of subjecting the image forming layer 1 to exposure and heating (heat development), and the oxidized product produced as a result of the reaction serves as the light-absorbing organic compound.

The photopolymerization initiator to be contained in the photosensitive image forming medium of the present invention is represented by the following Formula (I).

Dye$^{\oplus}$ 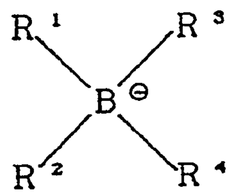 (I)

In the above Formula (I), Dye$^{\oplus}$ represents an cationic coloring matter moiety; $R^1$, $R^2$, $R^3$ and $R^4$ each independently represent a halogen atom, an alkyl group, an alkenyl group, an alkynyl group, an alicyclic group, an aryl group, an aryloxy group, an aralkyl group or a heterocyclic group, and may be the same as or different from each other; and $R^1$ and $R^2$, or $R^2$ and $R^3$ may combine to form a cyclic compound.

Of the photopolymerization initiators embraced in the above Formula (I), those having an absorption peak within the range of from 330 nm to 460 nm are preferred.

The photopolymerization initiator having an absorption peak within the above range enables stable formation of polymer images with good contrast since it can control the deviation of absorption peaks to be not more than 15 nm with respect to the light-absorbing organic compound as will be detailed later, produced as a result of the reaction between the reducing agent and organic silver salt.

In particular, when a reducing agent represented by Formula (II) as will be detailed later is used in the image forming medium, it is preferred to use as the photopolymerization initiator represented by Formula (I) a compound having an absorption peak within the range of from 330 nm to 430 nm, and more preferably from 380 nm to 430 nm. When a reducing agent represented by Formula (III) as will be detailed later is used in the image forming medium, it is preferred to use as the photopolymerization initiator represented by Formula (I) a compound having an absorption peak within the range of from 400 nm to 460 nm, and more preferably from 435 nm to 460 nm.

In Formula (I), coloring matters that can be used as the organic cationic coloring matter represented by Dye$^{\oplus}$ are exemplified by cyanine coloring matters, hemicyanine coloring matters, styryl coloring matters, thiazole coloring matters, oxazole coloring matters, thiadiazole coloring matters, vinyl coloring matters and aminovinyl coloring matters. Of these, it is preferred to use thiazole coloring matters, oxazole coloring matters, thiadiazole coloring matters and aminovinyl coloring matters. Preferred coloring matters Dye$^{\oplus}$ having the preferred absorption peak are those having a substituent on a benzene ring or heterocyclic ring, which substituent may preferably include an alkyl group, a halogen atom, an alkoxyl group, an aryl group, a nitro group and an amine group. In the case of, for example, a photopolymerization initiator having a symmetrical cyanine coloring matter, its absorption wavelength tends to shift with time probably because of the formation of a J-aggregate in the image forming medium. Hence, a compound having an asymmetrical structure is preferred as the organic cationic coloring matter.

The absorption peak of the photopolymerization initiator depends on the absorption peak of the organic cationic coloring matter. Preferred organic cationic coloring matters having an absorption peak within the range from 330 nm to 460 nm can be specifically shown as follows:

(1)

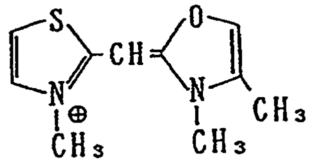

(absorption peak: 370 nm)

(2)

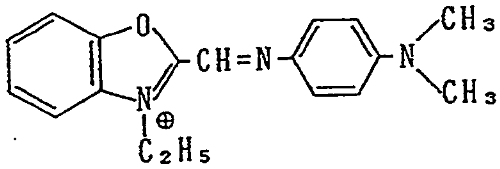

(absorption peak: 354 nm)

(3)

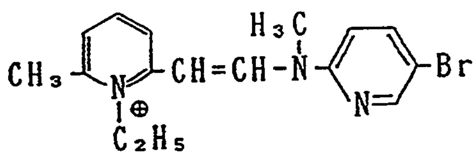

(absorption peak: 398 nm)

(4)

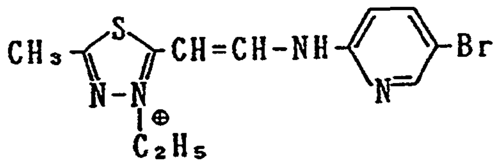

(absorption peak: 398 nm)

(5)

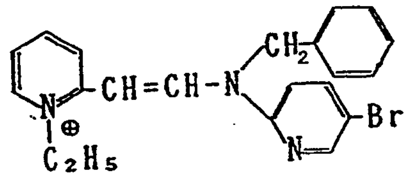

(absorption peak: 402 nm)

(6)

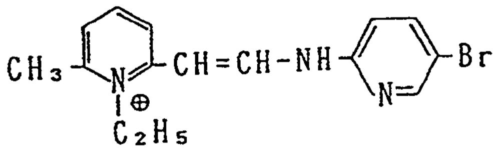

(absorption peak: 406 nm)

(7)

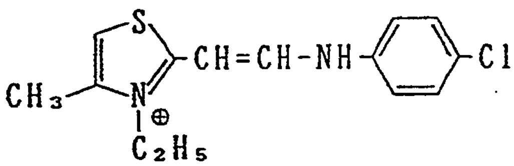

(absorption peak: 411 nm)

(8)

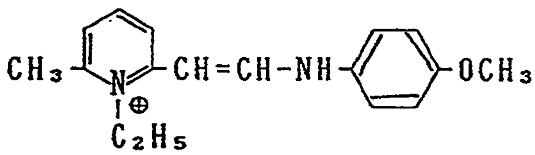

(absorption peak: 423 nm)

(9)

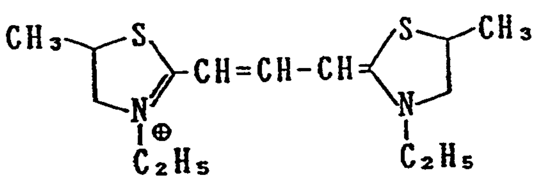

(absorption peak: 447 nm)

(10)

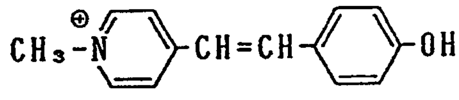

(absorption peak: 392 nm)

(11)

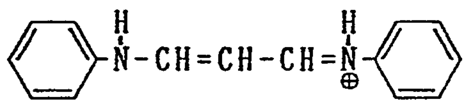

(absorption peak: 382 nm)

The halogen atom represented by $R^1$, $R^2$, $R^3$ and $R^4$ in Formula (I) may include a fluorine atom, a chlorine atom, a bromine atom and an iodine atom.

The alkyl group may preferably include a substituted or unsubstituted straight-chain or branched alkyl group having 1 to 10 carbon atoms, as exemplified by methyl, ethyl, propyl, iso-propyl, butyl, iso-butyl, t-butyl, amyl, iso-amyl, octyl, trifluoromethyl, methoxymethyl, ethoxymethyl, methoxyisopropyl, ethoxypropyl, N,N-dimethylaminoethyl, and N,N-dimethylaminopropyl.

The alkenyl group may preferably include those having 2 to 12 carbon atoms, as exemplified by a vinyl group, a propenyl group, a butenyl group, a pentenyl group, a hexenyl group, a heptenyl group, an octenyl group, a dodecynyl group and a pulenyl group.

The alkynyl group may preferably include those having 2 to 10 carbon atoms, as exemplified by an ethynyl group, a propagyl group, a butynyl group, a hexynyl group and a heptynyl group.

The alicyclic group may preferably include those having 5 to 8 carbon atoms, as exemplified by a cyclopentyl group, a cyclohexyl group, a cycloheptyl group and a cyclooctyl group. An alkyl group or the like may be substituted on any of these.

The aryl group may include a substituted or unsubstituted aryl group, as exemplified by a phenyl group, a naphthyl group, a fluorophenyl group, a chlorophenyl group, a dichlorophenyl group, a methoxyphenyl group, a tolyl group, a xylyl group, a chloronaphthyl group, a methoxynaphthyl group and a diphenylaminophenyl group.

The aryloxy group includes, for example, a phenoxy group, a naphthoxy group, a phenyldioxy group and a p-tolyloxy group.

The aralkyl group may include a substituted or unsubstituted aralkyl group, as exemplified by a benzyl group, a phenethyl group, an α-naphthylmethyl group, a β-naphthylmethyl group, a p-methoxybenzyl group and a p-chlorobenzyl group.

The heterocyclic group includes, for example, a pyridyl group, a quinolyl group, a lepidyl group, a methylpyridyl group, a furyl group, a thienyl group, an indolyl group, a pyrrole group, a carbazolyl group and N-ethylcarbazolyl group.

The borate anion in Formula (I) specifically includes, for example, tetramethyl borate, tetraethyl borate, tetrabutyl borate, triisobutylmethyl borate, di-t-butyl-dibutyl borate, trifluoromethyl trifluoroborate, tetraphenyl borate, tetra-p-chlorophenylborate, tetranisborate, triphenylmethyl borate, triphenylethyl borate, triphenylpropyl borate, triphenyl-n-butyl borate, trianisbutyl borate, triphenylhexyl borate, trimesitylbutyl borate, tritolylisopropyl borate, triphenylbenzyl borate, tetrabenzyl borate, triphenylphenethyl borate, triphenyl-p-chlorobenzyl borate, trimethallylphenyl borate, tricylohexylbutyl borate, tri(phenylethenyl)butyl borate, di(α-naphthyl)dipropyl borate, and diisopinocamphenyldiamyl borate. Particularly preferred are diphenyldibutyl borate, tetraphenyl borate, and trifluoromethyl trifluoroborate.

The borate anions used in the present invention can be obtained by the reaction between a boron compound such as triarylboron or boron trifluoride with a lithium compound or a nucleophilic reagent such as a Grignard reagent.

The image forming medium contains a reducing agent represented by the following Formula (II) or (III).

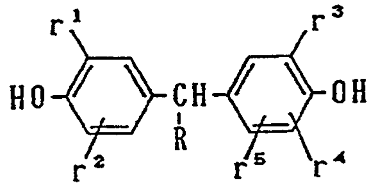

(II)

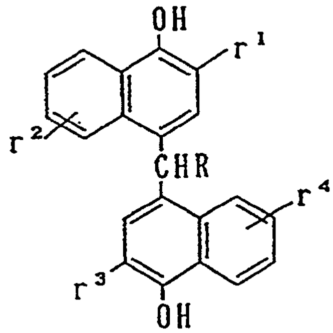

(III)

In the above Formulas (II) and (III), $r^1$ and $r^3$ each independently represent a hydrogen atom, a substituted or unsubstituted alkyl group, a substituted or unsubstituted cycloalkyl group or a substituted or unsubstituted aralkyl group; $r^2$, $r^4$ and $r^5$ each independently represent a hydrogen atom, a halogen atom, a substituted or unsubstituted alkyl group, a substituted or unsubstituted cycloalkyl group, a substituted or unsubstituted aryl group, a substituted or unsubstituted aralkyl group or an alkoxyl group, where $r^4$ and $r^5$ may combine to form a ring; and R represents a hydrogen atom, a substituted or unsubstituted alkyl group, a substituted or unsubstituted aryl group or a substituted or unsubstituted aralkyl group.

The halogen atom represented by $r^2$, $r^4$ and $r^5$ may include a fluorine atom, a chlorine atom, a bromine atom and an iodine atom.

The unsubstituted alkyl group represented by $r^1$, $r^2$, $r^3$, $r^4$, $r^5$ and R may preferably include a straight-chain or branched alkyl group having 1 to 18 carbon atoms, as exemplified by methyl, ethyl, propyl, iso-propyl, butyl, t-butyl, amyl, iso-amyl, sec-amyl, texyl, hexyl, heptyl, octyl, nonyl, dodecyl, and stearyl. The substituted alkyl group represented by $r^1$, $r^2$, $r^3$, $r^4$, $r^5$ and R may preferably include an alkoxyalkyl group having 2 to 18 carbon atoms, a halogenoalkyl group having 1 to 18 carbon atoms, a hydroxyalkyl group having 1 to 18 carbon atoms and an aminoalkyl group having 1 to 18 carbon atoms.

The alkoxylalkyl group includes, for example, methoxyethyl, ethoxymethyl, ethoxyethyl, ethoxypropyl, ethoxybutyl, propoxymethyl, propoxybutyl, i-propoxybutyl, t-butoxyethyl, and hexyloxybutyl.

The halogenoalkyl group includes, for example, chloromethyl, chloroethyl, bromoethyl, chloropropyl, chlorobutyl, chlorohexyl, and chlorooctyl.

The hydroxyalkyl group includes, for example, hydroxymethyl, hydroxyethyl, hydroxypropyl, hydroxybutyl, hydroxypentyl, hydroxyhexyl, and hydroxyheptyl.

The aminoalkyl group includes, for example, aminomethyl, acetylaminomethyl, dimethylaminomethyl, aminoethyl, acetylaminoethyl, dimethylaminoethyl, diethylaminoethyl, morpholinoethyl, piperidinoethyl, aminopropyl, diethylaminopropyl, dipropylaminoethyl, acetylaminopropyl, aminobutyl, and morpholinobutyl.

The substituted or unsubstituted cylcoalkyl group represented by $r^1$, $r^2$, $r^3$, $r^4$ and $r^5$ may preferably include those having 4 to 18 carbon atoms, as exemplified by cyclopentyl, cyclohexyl, cycloheptyl, cyclooctyl, methylcyclohexyl, dimethylcyclohexyl, and ethylcylohexyl.

The substituted or unsubstituted aralkyl group represented by $r^1$, $r^2$, $r^3$, $r^4$, $r^5$ and R may preferably include those having 7 to 19 carbon atoms, as exemplified by benzyl, phenetyl, benzhydryl, tolytyl, phenypropyl, naphthylmethyl, chlorobenzyl, dichlorobenzyl, methoxybenzyl, and methylbenzyl.

The substituted or unsubstituted aryl group represented by $r^2$, $r^4$, $r^5$ and R may preferably include those having 6 to 16 carbon atoms, as exemplified by phenyl, naphthyl, anthryl, phenanthryl, tolyl, xylyl, cumenyl, mesityl, chlorophenyl, methoxyphenyl, and fluorophenyl.

The alkoxyl group represented by $r^2$, $r^4$ and $r^5$ may preferably include those having 1 to 18 carbon atoms, as exemplified by methoxy, ethoxy, propoxy, i-propoxy, butoxy, and hexyloxy.

Of the above, the substituents preferred as $r^2$ and $r^4$ are a chlorine atom, a bromine atom, methyl, ethyl, i-propyl, t-butyl, sec-amyl, texyl, ethoxymethyl, ethoxyethyl, chloromethyl, hydroxymethyl, aminomethyl, dimethylaminomethyl, and benzyl. Particularly preferred substituents are a chlorine atom, methyl, t-butyl, and texyl.

Preferred substituents as $r^1$ and $r^3$ are a chlorine atom, methyl, ethyl, i-propyl, t-butyl, amyl, texyl, hydroxyl, chloromethyl, hydroxymethyl, benzyl, and cyclohexyl. Particularly preferred substitutents are a chlorine atom, methyl, t-butyl, and texyl.

Preferred reducing agents of the reducing agent represented by Formula (II) are exemplified by 2,6-di-t-butyl-4-(2-hydroxy-3-t-butylbenzyl)phenol, 2,6-di-t-butyl-4-(3,5-dichloro-4-hydroxybenzyl)phenol, 2,6-di-t-butyl-4-(3,5-dimethyl-4-hydroxybenzyl)phenol, 2,6-di-t-butyl-4-(3-t-butyl-4-hydroxybenzyl)phenol, 2,6-di-t-butyl-4-(3-cyclohexyl-4-hydroxybenzyl)phenol, 2-t-butyl-4-(2-hydroxy-3,5-dimethylbenzyl)-5-methylphenol, 4,4'-methylenebis(2,6-di-t-butylphenol), 4,4'-methylenebis(2-t-butyl-5-methylphenol), 4,4'-methylenebis(2-t-butyl-6-benzylphenol), 4,4'-methylenebis(2-t-butyl-6-methylphenol), 4,4'-ethylidenebis(2-6-di-t-butylphenol), 4,4'-ethylidenebis(2-t-butyl-6-methylphenol), 4,4'-propylidenebis(2,6-di-t-butylphenol), 4,4'-butylidenebis(2,6-di-t-butylphenol), 4,4'-butylidenebis(2-cyclohexyl-6-methylphenol), bis(3,5-di-t-butyl-4-hydroxyphenyl)phenylmethane, bis(3,5-di-t-butyl-4-hydroxyphenyl)(4-methoxyphenyl)methane, bis(3,5-di-t-butyl-4-hydroxyphenyl)(4-dimethylaminophenyl)methane, tris(3,5-di-t-butyl-4-hydroxyphenyl)methane, 2-methyl-4-(3,5-dimethyl-4-hydroxyphenyl)methyl-1-naphthol, 2-t-butyl-4-(3,5-dimethyl-4-hydroxyphenyl)methyl-1-naphthol, 2-methyl-4-(3,5-dibutyl-4-hydroxyphenyl)methyl-1-naphthol, and 2-methyl-4-(3,5-di-i-propyl-4-hydroxyphenyl)methyl-1-naphthol.

Preferred reducing agents of the reducing agent represented by Formula (III) are exemplified by 4,4'-methylenebis(2-methyl-1-naphthol), 4,4'-methylenebis(2-t-butyl-1-naphthol), 4,4'-ethylidenebis(2-methyl-1-naphthol), 4,4'-ethylidenebis(2-t-butyl-1-naphthol), and bis(4-hydroxy-3-methylnaphthyl)phenylmethane.

Besides these reducing agents, any of conventionally known hydroquinones, pyrazolidones, alkoxynaphthols, phenols, o-bisphenols, hydrazines, etc. may be used in combination. In this instance, the reducing agent represented by Formula (II) or (III) may preferably be contained in an amount of not less than 30 % by weight, and more preferably 50 % by weight, based on the total weight of the reducing agents contained in the image forming medium of the present invention.

The reducing agents of Formulas (II) and (III) may also be used in combination.

The photosensitive silver halide used in the image forming medium of the present invention may include silver chloride, silver bromide, silver chlorobromide, silver iodobromide, and silver chloroiodobromide. These may have been subjected to chemical sensitization and optical sensitization as done in respect of usual photographic emulsions. More specifically, the chemical sensitization that can be used includes sulfur sensitization, noble metal sensitization, and reduction sensitization. The optical sensitization that can be applied includes methods using conventionally known sensitizing coloring matters.

The sensitizing coloring matters that may be preferably used include cyanine coloring matters, merocyanine coloring matters, and trinuclear coloring matters, as exemplified by 3,3'-dicarboxyethyl-2,2'-thiacarbocyanine iodide, 3,3'-diethyl-2,2'-thiacarbocyanine iodide, 3,3'-disulfoethyl-2,2'-thiadicarbocyanine bromide, 3,3'-diethyl-2,2'-thiatricarbocyanine iodide, and further the coloring matters having the following structural formula:

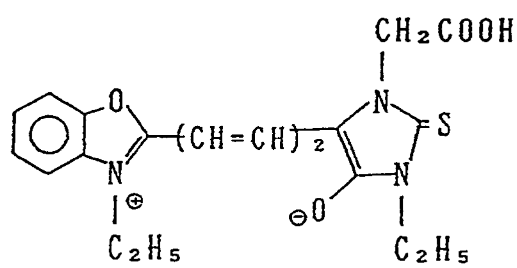

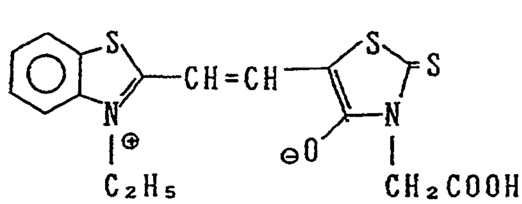

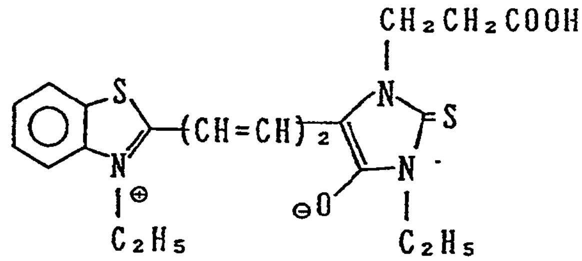

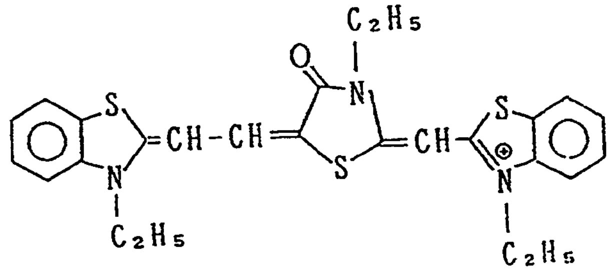

The halogen composition in a grain may be uniform, or the grain may have a multi-layer structure with different composition. It is also possible to use two or more kinds of silver halides having different halogen composition, grain size, grain size distribution, etc.

The organic silver salt that can be used in the medium of the present invention includes organic acid silver salts or triazole silver salts as described in SHASHIN KOGAKU NO KISO (Basic Photographic Engineering), First Edition, published 1982, The Non-silver Salt Volume, p.247, or japanese Patent Application Laid-open No. 59-55429. It is preferred to use silver salts having a low photosensitivity. They include, for example, silver salts of aliphatic carboxylic acids, aromatic carboxylic acids, thiocarbonyl compounds having a mercapto group or α-hydrogen, and imino group-containing compounds.

The aliphatic carboxylic acids include acetic acid, butyric acid, succinic acid, sebacic acid, adipic acid, oleic acid, linolic acid, lenolenic acid, tartaric acid, palmitic acid, stearic acid, behenic acid and camphor acid. In general, however, silver salts are not stabler as they have a smaller number of carbon atoms, and hence those having an appropriate number of carbon atoms (as exemplified by those having 16 to 26 carbon atoms) are preferred.

The aromatic carboxylic acids include benzoic acid derivatives, quinolinic acid derivatives, naphthalene carboxylic acid derivatives, salicylic acid derivatives, gallic acid, tannic acid, phthalic acid, phenyl acetic acid derivatives, and pyromellitic acid.

The compounds having a mercapto or thiocarbonyl group include 3-mercapto-4-phenyl-1,2,4-triazole, 2-mercaptobenzoimidazole, 2-mercapto-5-aminothiadiazole, 2-mercaptobenzothiazole, s-alkylthioglycolic acid (alkyl group carbon atom number of 12 to 22), dithiocarboxylic acids such as dithioacetic acid, thioamides such as thiostearoamide, and mercapto compounds such as 5-carboxy-1-methyl-2-phenyl-4-thiopyridine, mercaptotriazine, 2-mercaptobenzoxazole, mercaptooxadiazole, and 3-amino-5-benzylthio-1,2,4-triazole, which are described in U.S. Patent No. 4,123,274.

The compounds having an imino group typically include benzotriazole or derivatives thereof, described in Japanese Patent Publication No. 44-30270 or No. 45-18416, as exemplified by benzotriazole and alkyl-substituted benzotriazoles such as methylbenzotriazole, halogen-substituted benzotriazoles such as 5-chlorobenzotriazole, carboimidobenzotriazoles such as butylcarboimidobenzotriazole, nitrobenzotriazoles, described in Japanese Patent Application Laid-open No. 58-118639, sulfobenzotriazole, carboxybenzotriazole or salts thereof, or hydroxybenzotriazole, described in Japanese Patent Application Laid-open No. 58-115638, 1,2,4-triazole, described in U.S. Patent No. 4,220,709, or 1H-tetrazole, carbazole, saccharin, imidazole, and derivatives thereof.

As the polymerizable polymer precursor used in the image forming medium of the present invention, a compound having at least one reactive vinyl group in its molecule can be utilized. For example, it is possible to use one or more compounds selected from the group consisting of reactive vinyl group-containing monomers, reactive vinyl group-containing oligomers and reactive vinyl group-containing polymers.

The reactive vinyl group in these compounds includes substituted or unsubstituted vinyl groups having polymerization reactivity, as exemplified by styrene vinyl groups, acrylic acid vinyl groups, methacrylic acid vinyl groups, allyl vinyl groups, and vinyl ethers, as well as ester vinyl groups such as vinyl acetate.

Examples of the polymerizable polymer precursor satisfying such conditions are as follows.

They include, for example;

monovalent monomers such as styrene, methylstyrene, chlorostyrene, bromostyrene, methoxystyrene, dimethylaminostyrene, cyanostyrene, nitrostyrene, hydroxystyrene, aminostyrene, carboxystyrene, acrylic acid, methyl acrylate, ethyl acrylate, cyclohexyl acrylate, acrylamide, methacrylic acid, methyl methacrylate, ethyl methacrylate, propyl methacrylate, butyl methacrylate, phenyl methacrylate, cyclohexyl methacrylate, vinyl pyridine, N-vinylpyrrolidone, N-vinylimidazole, 2-vinylimidazole, N-methyl-2-vinylimidazole, propyl vinyl ether, butyl vinyl ether, isobutyl vinyl ether, β-chloroethyl vinyl ether, phenyl vinyl ether, p-methylphenyl vinyl ether, and p-chlorophenyl vinyl ether;

divalent monomers such as divinylbenzene, distyryl oxalate, distyryl malonate, distyryl succinate, distyryl glutarate, distyryl adipate, distyryl maleate, distyryl fumarate, distyryl β,β'-dimethylglutarate, distyryl 2-bromoglutarate, distyryl α,α'-dichloroglutarate, distyryl terephthalate, oxalic acid di(ethyl acrylate), oxalic acid di(methyl ethyl acrylate), malonic acid di(ethyl acrylate), malonic acid di(methyl ethyl acrylate), succinic acid di(ethyl acrylate), glutaric acid di(ethyl acrylate), adipic acid di(ethyl acrylate), maleic acid di(ethyl acrylate), fumaric acid di(ethyl acrylate), β,β'-dimethylglutaric acid di(ethyl acrylate), ethylenediacrylamide, propylenediacrylamide, 1,4-phenylenediacrylamide, 1,4-phenylenebis(oxyethyl acrylate), 1,4-phenylenebis(oxymethyl ethyl acrylate), 1,4-bis(acryloyloxyethoxy)cyclohexane, 1,4-bis(acryloyloxymethylethoxy)cyclohexane, 1,4-bis(acryloyloxyethoxycarbamoyl)benzene, 1,4-bis(acryloyloxymethylethoxycarbamoyl)benzene, 1,4-bis(acryloyloxyethoxycarbamoyl)cyclohexane, bis(acryloyloxyethoxycarbamoylcyclohexyl)methane, oxalic acid di(ethyl methacrylate), oxalic acid di(methyl ethyl methacrylate), malonic acid di(ethyl methacrylate), malonic acid di(methyl ethyl methacrylate), succinic acid di(ethyl methacrylate), succinic acid di(methyl ethyl methacrylate), glutaric acid di(ethyl methacrylate), adipic acid di(ethyl methacrylate), maleic acid di(ethyl methacrylate), fumaric acid di(ethyl methacrylate), fumaric acid di(methyl ethyl methacrylate), β,β'-dimethylglutaric acid di(ethyl methacrylate), 1,4-phenylenebis(oxyethyl methacrylate), and 1,4-bis(methacryloyloxyethoxy)cyclohexane acryloyloxyethoxyethyl vinyl ether;

trivalent monomers such as pentaerythritol triacrylate, pentaerythritol trimethacrylate, pentaerythritol tri(hydroxystyrene), dipentaerythritol hexaacrylate, cyanuric acid triacrylate, cyamuric acid trimethacrylate, 1,1,1-trimethylolpropane triacrylate, 1,1,1-trimethylolpropane trimethacrylate, cyanuric acid tri(ethyl acrylate), 1,1,1-trimethylolpropane tri(ethyl acrylate), cyanuric acid tri(ethyl vinyl ether), a condensate of a reaction product between 1,1,1-trimethylolpropane and three-fold mols of toluenediisocyanate, with hydroxyethyl acrylate, and a condensate of a reaction product between 1,1,1-trimethylolpropane and three-fold mols of hexanediisocyanate, with p-hydroxystyrene;

tetravalent monomers such as ethylene-tetraacrylamide, and propylenetetraacrylamide; and

those comprised of a polymeric compound having on its side chain a polymerizable unsaturated double bond. Two or more of these polymerizable polymer precursors may be used in combination.

For the purpose of improving film properties and dispersion, the image forming layer may be incorporated with a binder, which may be appropriately contained. The binder includes, for example, cellulose esters such as nitrocellulose, cellulose phosphate, cellulose sulfate, cellulose acetate, cellulose propionate, cellulose butyrate, cellulose myrystate, cellulose palmitate, cellulose acetate·propionate, and cellulose acetate·butyrate; cellulose ethers such as methyl cellulose, ethyl cellulose, propyl cellulose, and butyl cellulose; vinyl resins such as polystyrene, polyvinyl chloride, polyvinyl acetate, polyvinyl butyral, polyvinyl acetal, polyvinyl alcohol, and polyvinyl pyrrolidone; copolymer resins such as a styrene/butadiene copolymer, a styrene/acrylonitrile copolymer, a styrene/butadiene/acrylonitrile copolymer, and a vinyl chloride/vinyl acetate copolymer; acrylic resins such as polymethyl methacrylate, polymethyl acrylate, polybutyl acrylate, polyacrylic acid, polymethacrylic acid, polyacrylamide, and polyacrylonitrile; polyesters such as polyethylene terephthalate; polyacrylate resins such as poly(4,4'-isopropylidenediphenylene-co-1,4-cyclohexylenedimethylene carbonate), poly(ethylenedioxy-3,3'-phenylene thiocarbonate), poly(4,4'-isopropylidenediphenylene carbonate-co-terephthalate), poly(4,4'-isopropylidenediphenylene carbonate), poly(4,4'-sec-butylidenediphenylene carbonate), and poly(4,4'-isopropylidenediphenylene carbonate-block-oxyethylene); polyamides; polyimides; epoxy resins; phenol resins; polyolefins such as polyethylene, polypropylene, and chlorinated polyethylene; and natural polymers such as gelatin.

In addition to these, toning agents, antifoggants, alkali generating agents, automatic oxidants, etc. may be optionally added in the image forming medium of the present invention. The image forming layer 1 may also be provided with a protective layer comprising polyvinyl alcohol, polyethylene terephthalate or the like so that the polymerization reaction can be prevented from its inhibition due to oxygen and any damages ascribable to an external force can be prevented.

In the image forming medium of the present invention, the components described above may preferably be used in the proportion as follows:

The organic silver salt may preferably be contained in the image forming layer 1 in an amount of from 0.3 to 30 g/m$^2$, more preferably from 0.7 to 15 g/m$^2$, and particularly preferably from 1.2 to 8 g/m$^2$.

The photosensitive silver halide may preferably be contained in an amount of from 0.001 mol to 2 mols, more preferably from 0.05 mol to 0.4 mol, per mol of the organic silver salt. The reducing agent may preferably be contained in an amount of from 0.05 mol to 3 mols, and more preferably from 0.2 mol to 1.3 mol, per mol of the organic silver salt. The photopolymerization initiator may preferably be contained in an amount of from 0.1 part by weight to 30 parts by weight, and more preferably from 0.5 part by weight to 10 parts by weight, based on 100 parts by weight of the polymerizable polymer precursor. The photopolymerization initiator represented by Formula (I) may preferably be contained in an amount of from 0.0005 mol to 2.0 mols, and more preferably from 0.001 mol to 0.6 mols, per mol of the reducing agent.

The amount of the binder optionally contained in the image forming layer 1 may preferably be contained in an amount of from 0 to 10 parts by weight, and more preferably from 0.5 to 5 parts by weight, based on 1 part by weight of the organic silver salt. This proportion also applies in respect of the photosensitive layer 1a described later. The amount of the binder also optionally contained in the polymerizing layer 1b described later may preferably be contained in an amount of from 0 to 10 parts by weight based on 1 part by weight of the polymerizable polymer precursor.

The image forming medium of the present invention can be formed by dissolving the above components in a solvent together with a binder appropriately used, and coating the resulting solution on the support 2 such as metal foil, plastic film, paper, baryta paper or synthetic paper, or, when the strength is kept by the binder itself, by incorporating the above essential components into a film- or sheet-like material formed by the binder without use of the support 2.

The image forming layer 1 may preferably have a thickness of from 0.1 µm to 2 mm, and more preferably from 1 µm to 0.1 mm. The support 2 may also preferably have a thickness of from about 2 µm to about 3 mm.

The image forming layer 1 may be formed to have a multi-layer structure. For example, as shown in Fig. 2, the image forming layer 1 may be constituted of a photosensitive layer 1a and a polymerizing layer 1b, and formed on the support 2. In this instance, the photosensitive layer 1a contains at least the photosensitive silver halide, organic silver salt and reducing agent, and the polymerizing layer 1b contains at least the polymerizable polymer precursor and photopolymerization initiator.

The photosensitive layer 1a and the polymerizing layer 1b may each have a thickness ranging preferably from 0.05 µm to 1 mm, more preferably from 0.3 µm to 30 µm, and particularly preferably from 0.6 µm to 10 µm.

To the image forming layer 1, a chain transfer agent may preferably be added so that the radicals produced from borate salts can be effectively made contributory to the polymerization or cross-linking. In the case when the image forming layer is of double-layer structure, the chain transfer agent is incorporated into the polymerizing layer 1b.

The chain transfer agent may include amine compounds, halogen compounds, onium salt compounds and thiol compounds. Any compounds serving as this chain transfer agent may be used in an amount of 0.5 part by weight to 100 parts by weight, and more preferably from 3 parts by weight to 30 parts by weight, based on 10 parts by weight of the compound of Formula (I). It thus becomes possible to obtain a polymer image with a higher cross-link density. Examples of such compounds are listed below.

The amine compounds may include diethanolamine, triethanolamine, diethanolaniline, p-dimethylaminocyanobenzene, p-diethylaminocyanobenzene, methyl p-dimethylaminobenzoate, ethyl p-dimethylaminobenzoate, and ethyl p-diethylaminobenzoate.

The halogen compounds may include tetrabromomethane, tribromobutane, 2,4,6-tribromophenol, γ,γ,γ-trichlorophenylpropane, 2,4,6-tris(trichloromethyl)triazine, 2,4-bis(trichloromethyl)-6-methoxycarbonylethyltriazine, and 2-(p-methoxyphenyl)-4,6-bis(trichloromethyl) triazine.

The onium salt compounds may include aromatic iodonium salts and aromatic sulfonium salts, as exemplified by diphenyl iodonium, 4,4′-dimethyldiphenyl iodonium, 4,4′-di-t-butyldiphenyl iodonium, triphenylsulfonium or diphenyl (p-phenylthiophenyl)sulfonium having a counter ion such as $SbF_6^{\ominus}$, $AsF_6^{\ominus}$, $PF_6^{\ominus}$ or $BF_4^{\ominus}$.

The thiol compounds may include mercapto aromatic compounds, as exemplified by 2-mercaptobenzothiazole, 2-mercaptobenzooxazole, 2-mercaptobenzothiazole, 5-methyl-2-mercaptobenzoxazole, 5-methyl-2-mercaptobenzothiazole, and 5-ethyl-2-mercaptobenzothiazole.

Of these, the chain transfer agents such as amine compounds and halogen compounds are preferred in view of solvent solubility, stability and sensitivity.

Now, to form an image by using the image forming medium of the present invention, the image forming layer 1 on the support 2 is first imagewise exposed to light in a desired form in the step of imagewise exposure, according to analog exposure using a mask or the like, or digital exposure in which exposure is carried out using a laser or the like according to image signals such as external electric signals or light signals. As a result, silver

metal is produced from the photosensitive silver halide present in the imagewise exposed area, and this forms a latent image. The silver metal serves as a catalyst of the thermal reaction between the organic silver salt and reducing agent.

As conditions for the exposure to light in carrying out the writing of this latent image, conditions under which the resulting polymer image can obtain the desired performance such as sufficient contrast may be used by appropriately selecting them depending on the concentration, type and so forth of the silver halide incorporated into the image forming layer.

The image forming method of the present invention, which employs the photosensitive silver halide in the step of imagewise exposure, enables highly sensitive writing.

Next, in the step of heating, the image forming layer 1 in which the latent image has been formed is heated, so that the silver metal selectively acts as a catalyst in the imagewise exposed area, where the organic silver salt reacts with the reducing agent. The organic silver salt is reduced to a silver atom (metallic silver) and at the same time the reducing agent is oxidized to form an oxidized product. This oxidized product has light absorption.

The heating in this heating step is carried out under appropriate selection of conditions necessary for the progress of oxidation-reduction reaction and the formation of the light-absorbing organic compound. The heating temperature depends on the composition of mediums and can not be sweepingly defined. However, the heating may preferably be carried out at a temperature of from 60°C to 200°C, and more preferably from 70°C to 150°C, for 1 second to 5 minutes, and more preferably for 3 seconds to 60 seconds. In general, high temperatures can complete the heating in a short time and low temperatures may require the heating to be carried out for a long time.

A heating means includes a method in which a hot plate, a heat roll, a thermal head or the like is used, as well as a method in which a heating element provided on the support is electrified to carry out heating, or a method in which the heating is carried out by irradiation with laser beams.

Subsequently, in the step of polymerization, the image forming layer 1 is subjected to polymerization exposure. As a result of the polymerization exposure on the whole surface of the image forming layer 1, the polymerizable polymer precursor is polymerized by the action of the photopolymerization initiator, in the imagewise unexposed area. On the other hand, the light-absorbing organic compound is present at the imagewise exposed area, and therefore the light with wavelengths for the polymerization exposure is absorbed into that area, so that no polymerization proceeds there, compared with the imagewise unexposed area. Hence, a difference in the state of polymer formation occurs between the imagewise exposed area and imagewise unexposed area, so that a polymer area is selectively formed. In other words, there is formed the polymer image.

In the image forming medium of the present invention, an image may also be formed in the following way, utilizing the polymer image formed in the image forming medium.

For example, a heat-diffusible coloring matter is previously incorporated in the image forming layer 1 shown in Fig. 1 or the polymerizing layer 1b shown in Fig. 2, and the heat-diffusible coloring matter is transferred to an image receiving medium according to the step of transfer as described below. An image is thus formed.

Namely, an image receiving medium is laminated on the image forming layer 1 in which the polymer image has been formed, followed by heating. As a result, the heat-diffusible coloring matter the image forming medium previously contains is diffusion-transferred to the image receiving medium, corresponding with the latent image, and thus an image comprised of the heat-diffusible coloring matter is formed on the image receiving medium (Transfer step).

The image formation according to the above transfer step, in which the amount of transfer of the heat-diffusible coloring matter can be controlled according to the degree of polymerization (the amount of transfer of the heat-diffusible coloring matter decreases with an increase in the degree of polymerization), makes it possible to readily obtain an image with density gradation.

In the instance of the image forming medium shown in Fig. 2, the heat-diffusible coloring matter may be transferred in the state that the polymerizing layer 1b and image receiving medium are directly laminated, after the photosensitive layer 1a has been removed, but it is also possible to carry out the thermal transfer of the heat-diffusible coloring matter in the state that the photosensitive layer 1a is provided. When the photosensitive layer 1a is removed, the binder used in the photosensitive layer 1a should be a binder that enables easy peeling of the photosensitive layer 1a from the polymerizing layer 1b.

The mechanism by which the diffusibility of the heat-diffusible coloring matter in the polymerized area is controlled is that the molecular chain of the polymer can be loosened with difficulty even when the polymerized area is heated, as a result of the polymerization of the polymerizable polymer precursor, and thus the heat-diffusible coloring matter is inhibited from being diffused.

In the instance where the image is formed using the heat-diffusible coloring matter, the heat-diffusible coloring matter may not be incorporated in the image forming layer 1 or polymerizing layer 1b, and instead a coloring material layer containing the heat-diffusible coloring matter may be provided between the image forming layer 1 and support 2 or between the polymerizing layer 1b and support 2. The image attributable to the heat-diffusible coloring matter can also be thereby formed in the same way as the previously described.

The heat-diffusible coloring matter may be contained in an amount of from 5 parts by weight to 200 parts by weight, and more preferably from 10 parts by weight to 100 parts by weight, based on 100 parts by weight of the total sum of the silver halide, organic silver salt, reducing agent, polymerizable polymer precursor, photopolymerization initiator and the binder optionally contained.

In the instance where the heat-diffusible coloring matter is contained in the polymerizing layer 1b, the heat-diffusible coloring matter may suitably be contained in an amount of from 5 to 60 % by weight based on the polymerizing layer 1b. In the instance where the coloring material layer is provided, the heat-diffusible coloring matter may preferably be contained in an amount not less than 5 % based on the coloring material layer. The coloring material layer can also be constituted of only the heat-diffusible coloring matter.

The heat-diffusible coloring matter used in the present invention includes, for example, monoazo dyes, thiazole dyes, anthraquinone dyes, triallylmethane dyes, rhodamine dyes, and naphthol dyes. The heat-diffusible coloring matter, in general, has a larger heat-diffusibility as the molecular weight becomes smaller, and also has a smaller heat-diffusibility as the dye has more polar groups as exemplified by a carboxyl group, an amino group, a hydroxyl group, a nitro group and a sulfone group. Hence, coloring matters having the desired heat-diffusibility may be appropriately selected on the basis of the molecular weight and polar groups, depending on the degree of polymerization or crosslink density and heating conditions in the image forming medium of the present invention.

There are no particular limitations on the image receiving medium used in the step of transferring the heat-diffusible coloring matter, so long as it enables good transfer of the heat-diffusible coloring matter and is capable of forming a good image. It may be a plain paper, but preferably be comprised of a substrate provided thereon with an image receiving layer so that the heat-diffusible coloring matter may be transferred to this image receiving layer. As the image receiving layer, various materials can be used, as exemplified by polyester resins, polycarbonate resins, polyvinyl acetate resins, polyurethane resins, polyamide resins, polycaprolactam resins, and polyvinyl chloride resins.

Preferred values for the heating temperature in the transfer step may vary depending on various conditions such as the type of the heat-diffusible coloring matter and the degree of polymerization of the polymer, but may range from 80°C to 250°C, and preferably from 80°C to 200°C.

After the above transfer step, the image forming medium may be peeled from the image receiving medium. Thus, the heat-diffusible coloring matter is transferred to the image receiving medium and an image can be obtained. The image obtained through the transfer step is an image having a superior contrast to give an image having a superior brightness and chroma.

In the instance where the image is formed in the state that the heat-diffusible coloring matter is contained in the image forming medium of the present invention, a plurality of image forming mediums containing heat-diffusible coloring matters having colors different from each other, e.g., yellow, magenta, cyan, and also black, may be used to form images with the respective colors, superposed on a single image receiving medium, whereby an image with multiple colors can also be formed. Such an image with multiple colors can also be formed by an image forming medium comprising a single support having thereon an image forming layer (or a polymerizing layer, or a coloring material layer) containing heat-diffusible coloring matters with different colors (for example, yellow, magenta, cyan, and also black) in the state separated into regions for the respective colors. Namely, the heat-diffusible coloring matters may be successively transferred from the required color regions and the images with the respective colors may be superposed each other, so that the image with multiple colors can be formed.

The polymer image can also be separated to the image receiving medium side and support side, utilizing the difference in adhesion between the area sufficiently polymerized and the area at which no polymerization has proceeded (Peeling-apart).

In this instance, an image receiving medium is laminated on an image forming layer, where, after the step of polymerization has been completed, the image receiving medium is peeled from the image forming medium. As a result, the polymer image is separated at the area sufficiently polymerized and the area at which no polymerization has proceeded, and thus a positive image and a negative image can be obtained.

In the above peeling-apart, whether or not the area sufficiently polymerized and the area at which no polymerization has proceeded are separated when the image receiving medium is peeled depends on how the materials for the image receiving medium, support, image forming layer, etc. are selected.

The image receiving medium used in the peeling-apart includes, for example, art paper, coated paper, films, and metallic foil. In the step of carrying out the peeling-apart, heating may not necessarily be required, but the image forming medium and image receiving medium may preferably be heated to about 40°C to about 150°C

to carry out the transfer. The peeling-apart may also be carried out under a pressure of,from 0.5 kg/cm$^2$ to 400 kg/cm$^2$, and preferably from 1 kg/cm$^2$ to 150 kg/cm$^2$.

The polymer image may further be colored by selectively adhering a powder such as toner, or an ink, to the polymer image, utilizing the difference in adhesion or the difference in hydrophilic nature (or hydrophobic nature) between the polymerized area and unpolymerized area of the polymer image. The powder such as toner, or the ink, adhered to the polymer image may further be transferred to an image receiving medium such as paper. The unpolymerized area of the polymer image may also be removed by etching to give an image comprised of the polymerized area.

The present invention will be described below in greater detail by giving Example. In the following description, the "part(s)" that indicates a weight proportion is by weight unless particularly referred to.

Example 1

Using a homomixer, a dispersion composed of the following was prepared.

| | |
|---|---|
| Behenic acid | 4.0 parts |
| Silver behenate | 4.5 parts |
| Xylene | 50 parts |
| n-Butanol | 50 parts |

To the resulting dispersion, 0.6 part of silver bromide with an average grain size of 0.08 µm and a cubic form was added, and 5.0 parts of polyvinyl butyral and 5.0 parts of dipentaerythritol hexaacrylate were further added.

The dispersion was taken up in a quantity of 12 parts, and the following solution was added and thoroughly mixed, and the solution obtained was coated on a polyethylene terephthalate film in a dried coating thickness of 5 µm. On the coating thus formed, a protective layer comprising polyvinyl alcohol was provided in a thickness of 2 µm. Thus an image forming medium of the present invention was produced.

Phthaladinone 0.1 part

4,4'-Methylenebis(2-methyl-1-naphthol) 0.32 part

(An image having an absorption peak at 448 nm is produced as a result of exposure and heating)

Ethyl p-dimethylaminobenzoate 0.25 part

Triphenylbutyl borate with the following structural formula: 0.14 part

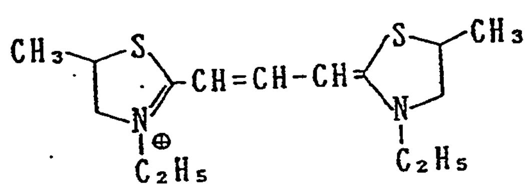

(The dye (9) previously described.)

Xylene 6.0 parts

The above image forming medium was imagewise exposed to light for 5 seconds at an image-surface illuminance of 1,000 lux using a tungsten lamp. Then, heating was carried out at 115°C for 10 seconds. As a result, the exposed areas were developed. Subsequently, using three fluorescent lamps (electric power: 15 W) having

a fluorescent peak at 450 nm, the image forming medium was uniformly exposed for 10 seconds, with a distance of 30 mm from the medium.

After the protective layer was removed by washing with water, etching was carried out using an ethanol bath. As a result, a sharp polymer image corresponding with unexposed areas remained on the film.

A sharp polymer image was also forced when the uniform exposure using the fluorescent lamps was carried out for a time shortened to 5 seconds.

Example 2

On an aluminum plate of 0.5 μm in thickness, a solution composed of the following was coated in a dried coating thickness of 6 μm to form a polymerizing layer.

| | |
|---|---|
| Polymethyl methacrylate | 3 parts |
| Chlorinated polyethylene | 6 parts |
| Dipentaerythritol hexaacrylate | 10 parts |
| Trimethylolpropane triacrylate | 5 parts |
| Triphenylbutyl borate with the following structural formula: (absorption peak: 398 μm | 2.2 part |

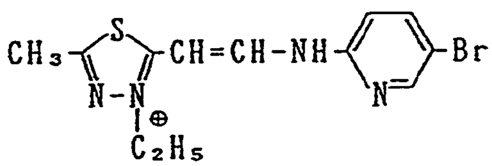

(The dye (4) previously described.)

| | |
|---|---|
| 4-Dimethylaminobenzoate | 1.0 part |
| 2,4,6-Tris(trichloromethyl)-S-triazene | 1.0 part |
| Toluene | 80 parts |
| Methyl ethyl ketone | 80 parts |

Next, on a polyethylene terephthalate (PET) film of 25 μm in thickness, a dispersion composed of the following was coated in a dried coating thickness of 4 μm to provide a photosensitive layer. On this photosensitive layer, a polyvinyl alcohol layer was further provided by coating in a dried coating thickness of 2 μm.

thickness of 2 μm.

| | |
|---|---|
| Behenic acid | 4.0 parts |
| Azelaic acid | 0.4 part |
| Silver behenate | 4.5 parts |
| Silver bromide | 1.0 part |
| Phthaladinone | 1.0 part |
| polyvinyl butyral | 5.0 parts |
| Methyl methacrylate copolymer | 10.0 parts |
| 2,6-Di-t-butyl-4-(3,5-dimethyl-4-hydroxybenzyl)phenol | 3.5 parts |

(An image having an absorption peak at 395 nm is produced as a result of exposure and heating)

Dimethylformamide solution of 1 % by weight of a dye having the following structural formula: 1.0 part

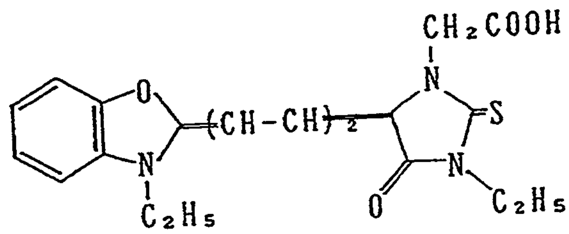

| | |
|---|---|
| Xylene | 60 parts |
| n-Butanol | 60 parts |

The PET film thus coated was laminated on the polymerizing layer. An image forming medium of the present invention was thus obtained.

The image forming medium of the present invention, thus produced, was imagewise exposed to light using a printer having a He-Ne laser, followed by heating at 130°C for 15 seconds. Subsequently, using three fluorescent lamps (electric power: 15 W) having a fluorescent peak at 390 nm, this image forming medium was uniformly exposed for 5 seconds, with a distance of 15 mm from the medium. Thereafter the PET film was peeled. As a result, a polymer image remained on the aluminum plate.

This aluminum plate, used as a printing plate, was secured to a simplified printer, and printing was carried out at a printing speed of 120 sheets per minute. As a result, no deterioration of images was seen on prints obtained after 20 minutes, compared with those at the initial stage.

In the above, the exposure was carried out using fluorescent lamps kept 5 mm more distant than 15 mm (at a distance of 20 mm). As a result, a good polymer image was similarly obtained. Good prints were also obtained when the aluminum plate was used as a printing plate.

## Comparative Example 1

An image forming medium was produced in the same manner as in Example 2 except that 2.2 parts of

triphenylbutyl borate, the dye (4), and 3.5 parts of 2,6-di-t-butyl-4-(3,5-dimethyl-4-hydroxybenzyl)phenol used in Example 2 were replaced with 0.85 part of 2-chlorothioxanthone and 3.5 parts of 2,2'-methylenebis(4-methyl-6-t-butylphenol), respectively.

A printing plate was prepared from this image forming medium in the same manner as in Example 2 and printing was carried out. As a result, deterioration of images began to occur after 5 minutes, where part of the polymer image formed on the aluminum plate was peeled.

The same resulted also when the amount of 2-chlorothioxanthone was increased from 0.85 part to 1.7 parts, and it was impossible to continue the printing for 20 minutes.

## Example 3

On a PET film of 50 μm in thickness, a solution composed of the following was coated in a dried coating thickness of 2 to 3 μm to form a coloring material layer.

| | |
|---|---|
| Polybutyl methacrylate | 7.0 parts |
| MS-Magenta-VP | 0.7 part |
| (produced by Mitsui Toatsu Chemicals, Inc.) | |
| Methyl ethyl ketone | 60 parts |

Besides the above, on a PET film of 25 μm in thickness, the following composition was coated in a dried coating thickness of 4 μm to form a polymerizing layer.
Polymerizable binder comprising polyvinyl butyral to the side chains of which acrylic groups were bonded in

| | |
|---|---|
| 18% mole through ester linkages | 5.0 parts |
| Trimethylolpropane triacrylate | 3.0 parts |
| Trianisbutyl borate with the following structural formula: | 2.0 parts |
| (absorption peak: 423 nm) | |

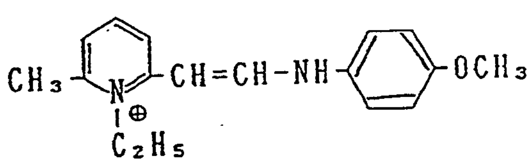

(The dye (8) previously described.)

| | |
|---|---|
| 4-Dimethylaminobenzoate | 1.4 parts |
| Toluene | 40 parts |
| Methyl ethyl ketone | 40 parts |

Next, on the opposite side of the PET film on which the polymerizing layer was formed, the following composition was coated in a dried coating thickness of 5 μm to provide a photosensitive layer. On this photosensitive layer, a polyvinyl alcohol layer was further coated in a dried coating thickness of 2 μm.

| | |
|---|---|
| Behenic acid | 4.0 parts |
| Azelaic acid | 0.4 part |
| Silver behenate | 4.5 parts |
| Silver bromide | 1.0 part |
| Phthaladinone | 1.0 part |
| polyvinyl butyral | 5.0 parts |
| 2-Methyl-4-(3,5-di-t-butyl-4-hydroxylphenyl)methyl-1-naphthol | 3.9 parts |

(An image having an absorption peak at 415 nm is produced as a result of exposure and heating)

Dimethylformamide solution of 1 % by weight of a dye having the following structural formula: 1.0 part

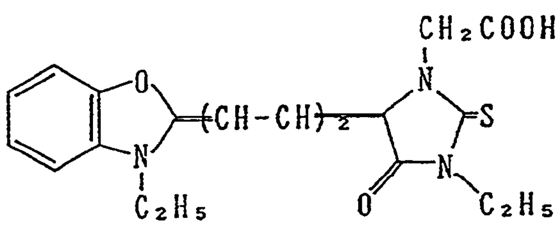

| | |
|---|---|
| Xylene | 60 parts |
| n-Butanol | 60 parts |

The above PET films were laminated in such a way that the polymerizing layer and coloring material layer formed thereon were superposed face-to-face. An image forming medium of the present invention was thus produced.

The image forming medium thus obtained was imagewise exposed to light in the same manner as in Example 2, followed by heating at 115°C for 10 seconds and then uniform exposure for 5 seconds using an ultrahigh-pressure mercury lamp. The photosensitive layer was peeled together with its PET film and then a polyester-coated image receiving paper was superposed onto the polymerizing layer, which were then passed between heat rollers with a nip width of 4 mm, controlled to have a temperature of 115°C, at a speed of 2 mm/sec. As a result, a magenta image corresponding with the imagewise exposed areas was formed on the image receiving paper. The resulting magenta image had a maximum optical density of not less than 1.5 and a fog density of not more than 0.02

Comparative Example 2

An image forming medium was produced in the same manner as in Example 3 except that the trianisbutyl borate, the dye (8) as a photopolymerization initiator, and 3.9 parts of 2-methyl-4-(3,5-di-t-butyl-4-hydroxylphenyl)methyl-1-naphthol were replaced with 0.9 part of 7-methoxy-3-benzoylcumarine having an absorption peak at 348 nm and 3.7 parts of 2,2'-methylenebis(4-methyl-6-t-butylphenol), respectively. Subsequently, the

imagewise exposure and heating were carried out in the same manner as in Example 3, followed by uniform exposure for 10 seconds using an ultrahigh-pressure mercury lamp, and thereafter the transfer of the dye was effected in the same manner as in Example 3. As a result, the image formed had a fog density of 0.02 but a maximum optical density of 1.2. The uniform exposure was also carried out for a time shortened to 5 seconds. As a result, the image showed a fog density of 0.06 and a maximum optical density of 1.4.

## Claims

1. An image forming medium comprising an image forming layer containing at least a polymerizable polymer precursor, a photopolymerization initiator represented by the following Formula (I), a photosensitive silver halide, an organic silver salt and a reducing agent represented by the following Formula (II) or (III).

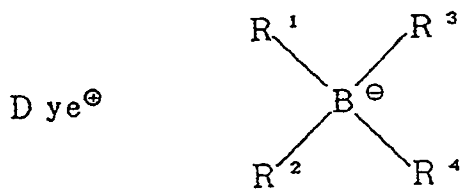

(I)

wherein $Dye^{\oplus}$ represents a cationic coloring matter moiety; $R^1$, $R^2$, $R^3$ and $R^4$ each independently represent a halogen atom, an alkyl group, an alkenyl group, an alkynyl group, an alicyclic group, an aryl group, an aryloxy group, an aralkyl group or a heterocyclic group, and may be the same as or different from each other; and $R^1$ and $R^2$, or $R^2$ and $R^3$ may combine to form a cyclic compound.

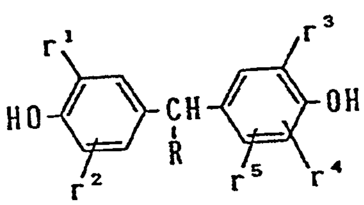

(II)

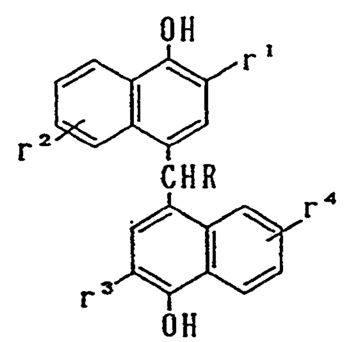

(III)

wherein $r^1$ and $r^3$ each independently represent a hydrogen atom, a substituted or unsubstituted alkyl group, a substituted or unsubstituted cycloalkyl group or a substituted or unsubstituted aralkyl group; $r^2$, $r^4$ and $r^5$ each independently represent a hydrogen atom, a halogen atom, a substituted or unsubstituted alkyl group, a substituted or unsubstituted cycloalkyl group, a substituted or unsubstituted aryl group, a substituted or unsubstituted aralkyl group or an alkoxyl group, where $r^4$ and $r^5$ may combine to form a ring; and R represents a hydrogen atom, a substituted or unsubstituted alkyl group, a substituted or unsubstituted aryl group or a substituted or unsubstituted aralkyl group.

2. An image forming medium according to Claim 1, wherein said photopolymerization initiator represented by Formula (I) has an absorption peak within the range of from 330 nm to 460 nm.

3. An image forming medium according to Claim 1, wherein said photopolymerization initiator represented

by Formula (I) has an absorption peak within the range of from 330 nm to 420 nm and said reducing agent is the compound represented by Formula (II).

4. An image forming medium according to Claim 1, wherein said photopolymerization initiator represented by Formula (I) has an absorption peak within the range of from 400 nm to 460 nm and said reducing agent is the compound represented by Formula (III).

5. An image forming medium according to Claim 1, wherein said Dye$^{\oplus}$ has an asymmetric structure.

6. An image forming medium according to Claim 1, wherein said image forming layer comprises a photosensitive layer and a polymerizing layer; said photosensitive layer containing at least said photosensitive silver halide, said organic silver salt and said reducing agent represented by Formula (II) or (III), and said polymerizing layer containing at least said polymerizable polymer precursor and said photopolymerization initiator represented by Formula (I).

7. An image forming medium according to Claim 1, wherein a coloring material layer containing a heat-diffusible coloring matter is laminated on said image forming layer.

8. A recording medium having an image receiving layer comprising a silver halide, an organic silver salt, a reducing agent, a polymerizable polymer precursor and a photopolymerization initiator represented by the formula (I) as defined in claim 1.

9. A recording medium having an image receiving layer comprising a silver halide, an organic silver salt, a reducing agent, a polymerizable polymer precursor and a photopolymerization initiator having an absorption peak within the range 330nm to 460nm.

10. A recording medium having an image receiving layer comprising a silver halide, an organic silver salt, a polymerizable polymer precursor, a photopolymerization initiator and a reducing agent of formula (II) or (III) as defined in claim 1.

11. A method for forming an image comprising the steps of:
(a) providing a recording medium having an image receiving layer comprising a silver halide, an organic silver salt, a reducing agent, a photopolymerizable polymer precursor and a polymerization initiator;
(b) imagewise exposing the medium to the light to form a metallic silver latent image in the silver halide present;
(c) developing the latent image by heating the medium to cause a reaction to take place in areas where metallic silver is present to act as a catalyst between the organic silver salt and the reducing agent, which reaction results in the image wise formation of a light-absorbent compound, and;
(d) flood exposing the medium to bring about a polymerization reaction in regions where the light absorbent compound has not formed,
characterised by selecting firstly the reducing agent and or the silver salt and secondly the photopolymerization initiator so that the absorption peak of the light absorbent compound is not more than about 15nm from that of the polymerization initiator.

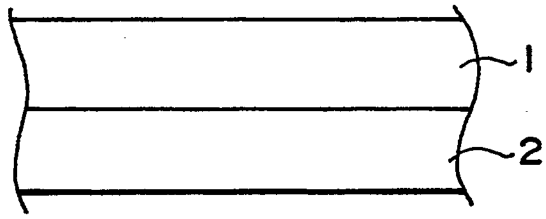


FIG. 1

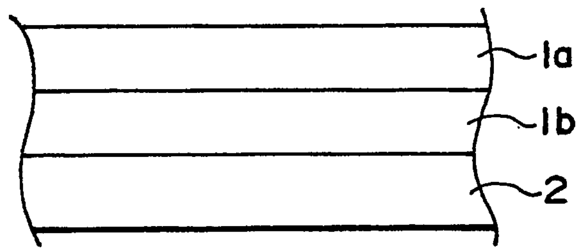


FIG. 2